# EUROPEAN PATENT SPECIFICATION

(11) **EP 0 454 955 B1**
(45) Date of publication and mention of the grant of the patent: **29.11.1995**
(21) Application number: 91102080.8
(22) Date of filing: 14.02.1991
(51) Int. Cl.: H03L 7/183, H04N 5/93

(54) **Sampling clock generating circuit**
Schaltung zur Erzeugung eines Abtasttaktes
Circuit de génération d'une horloge d'échantillonnage

(30) Priority: 30.03.1990 JP 86274/90
(43) Date of publication of application: 06.11.1991
(73) Proprietor: MITSUBISHI DENKI KABUSHIKI KAISHA, Tokyo 100 (JP)
(72) Inventor: Maeshima, Kazuya, 6-14, Maruomachi Nagasaki-shi, Nagasaki (JP)
(74) Representative: Eisenführ, Speiser & Partner

(56) References cited:
- US-A- 3 824 379
- US-A- 4 757 264
- US-A- 4 772 950
- PATENT ABSTRACTS OF JAPAN vol. 6, no. 81 (E-107)(959) May 19, 1982 & JP-A-57 20 074 (HITACHI SEISAKUSHO K.K. ) February 2, 1982

## Description

The invention relates to a sampling clock output generating circuit for generating a sampling clock output on the basis of a horizontal synchronization signal of a video signal, comprising: a variable frequency master clock oscillator working as a frequency synthesizer having a PLL loop comprising a reference oscillator of a stable frequency f_{ref}, a phase comparator, a low-pass filter, a first programmable frequency divider with a dividing ratio of N_{M}, N_{M} being an integer number, and a voltage controlled oscillator providing a preset master clock frequency of f_{ref} - N_{M}; and a second programmable frequency divider having a counter and a dividing ratio of N_{S}. Such a circuit is known from US-A-4,757,264.

Moreover, JP-A-5720074 discloses a sampling circuit for a video signal, and Fig. 1 is a block diagram of such a conventional sampling clock generating circuit. In the figure, indicated by 4 is a phase comparator for comparing the phase of a signal which is produced through the frequency division of the sampling clock with the phase of the horizontal sync signal so as to produce an error signal, 5 is a low-pass filter for smoothing the error signal, 6 is a voltage-controlled oscillator varying its oscillation frequency in response to the control voltage level, and 7 is a programmable frequency divider which divides the sampling clock frequency at a preset dividing ratio N. In JP-A-5720074, a further frequency divider (not shown in Fig. 1) reset by the horizontal sync signal is connected to the VCO 6 to produce the final sampling clock frequency.

Next, the operation of the circuit will be explained.

The sampling clock is divided at a preset dividing ration N in the programmable frequency divider 7. The programmable frequency divider 7 produces an output signal, which is compared in phase with the horizontal synch signal by the phase comparator 4, which then produces an error signal indicative of the phase difference between the two signals. The error signal is smoothed by the low-pass filter 5, and the resulting signal becomes the control voltage for the voltage-controlled oscillator 6. The voltage-controlled oscillator 6 varies its oscillation frequency in response to the control voltage. This circuit arrangement of phase-locked loop (PLL) provides a sampling clock which is equal in phase with the horizontal sync signal and has a frequency N times the horizontal sync frequency.

It is difficult to design a voltage-controlled oscillator which operates stably in a wide frequency range. Therefore, in case the sampling clock is required to have a wide frequency range, several voltage-controlled oscillators having various frequency ranges are used by switching, or the sampling clock is extracted out of an intermediate stage of a programmable counter.

The conventional circuit as described above depends, for the stability of sampling clock, largely on the stability of the externally-supplied horizontal sync signal, and therefore there is such a problem as the sampling clock can sample normally only video signals having stable horizontal sync signals.

In addition, there is another problem such as it is difficult to construct a stable PLL since different horizontal sync frequencies need different comparison frequencies.

The present invention is intended to solve the foregoing problems, and its prime object is to provide such a sampling clock generating circuit as it generates stable sampling clocks even in case externally-supplied horizontal sync signals have various frequencies or a horizontal sync signal has a degraded stability.

According to the invention, a sampling clock output generating circuit as defined in the preamble of claim 1 is characterized in that the counter has four outputs and is reset by the horizontal synchronization signal and by a coincidence signal produced by a comparator when the count value of said counter coincides with a preset value that corresponds to the dividing ratio of N_{S} of the counter for dividing the frequency of the voltage controlled oscillator so as to produce the sampling clock output synchronized with the horizontal synchronization signal and having a pulse repetition frequency of f_{ref} · N_{M}/N_{S}; and that a selector is provided for selecting one of the four outputs of the counter as sampling clock output according to the dividing ratio N_{S}.
Fig. 1 is a block diagram showing a conventional sampling clock generating circuit as known from JP-A-5720074;
Fig. 2 is a block diagram showing the sampling clock generating circuit based on an embodiment of the present invention;
Fig. 3 is a circuit diagram showing an example of the programmable frequency divider; and
Fig. 4 is a timing chart showing, as an example, the operation of the programmable frequency divider.

An embodiment of the present invention will be described with reference to the drawings.

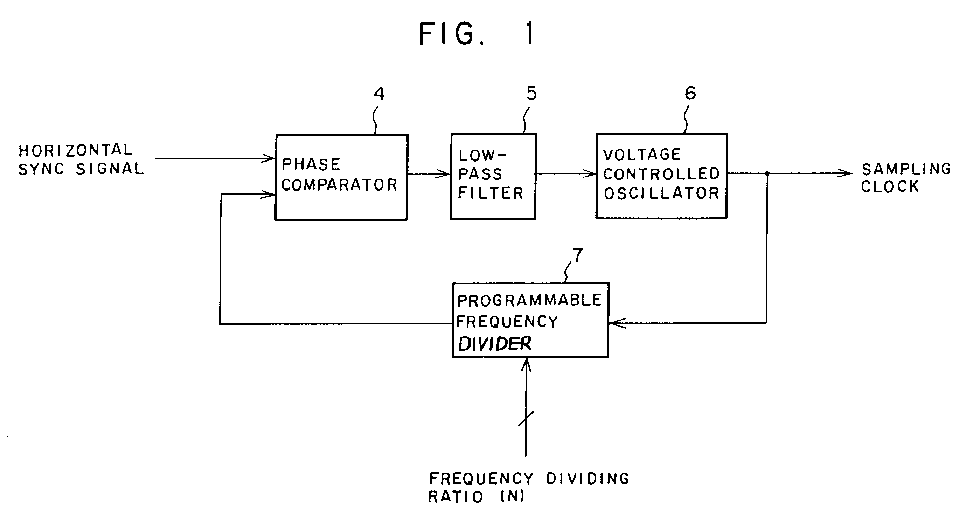

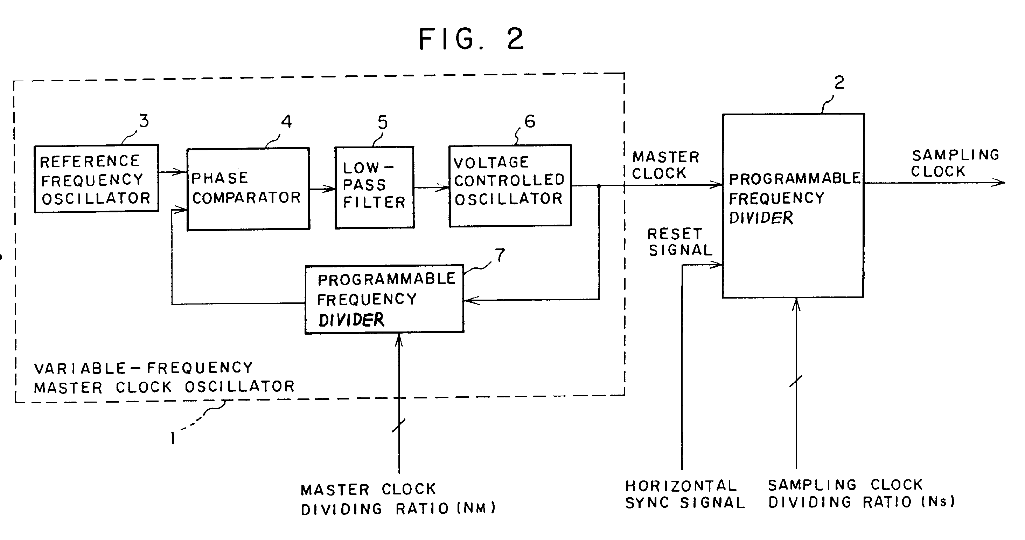

In Fig. 2, indicated by 1 is a variable-frequency master clock oscillator based on the scheme of frequency synthesizer, generating frequency which is N_{M} times a reference frequency as a master clock frequency, and 2 is a programmable frequency divider which divides the master clock frequency at a sampling clock dividing ratio N_{S} which is set from outside and is reset by a horizontal sync signal which is provided for from outside so that it produces a sampling clock. The master clock oscillator 1 includes a reference frequency oscillator 3 such as a crystal oscillator, a phase comparator 4 which compares the phase of a signal, which is derived through division from the master clock, with the phase of the reference clock so as to produce an error signal, a low-pass filter 5 which smoothes the error signal, a voltage-controlled oscillator 6 which varies the oscillation frequency in response to the control voltage level, and a programmable divider 7 which divides the master clock frequency at a frequency dividing ratio N_{M}.

Next, the operation of the circuit will be explained.

The master clock oscillator 1 is of PLL configuration, and it controls the master clock frequency so that the frequency becomes N_{M} times the reference frequency. The reference frequency osicllator 3 generates a stable reference clock. The phase comparator 4 compares in phase the reference clock with the signal which is derived from the master clock through division by the programmable frequency divider 7 at a preset dividing ratio N_{M}, and produces an error signal indicative of the phase difference of the two signals. The error signal is smoothed by the low-pass filter 5, and it becomes the control voltage for the voltage-controlled oscillator 6. The voltage-controlled oscillator 6 varies its oscillation frequency in response to the control voltage.

In this manner, the master clock frequency is controlled to be a frequency which is N_{M} times the reference frequency. The programmable frequency divider 2 is reset by the horizontal sync signal, and divides the master clock at the preset sampling clock dividing ratio N_{S} so as to produce a sampling clock.

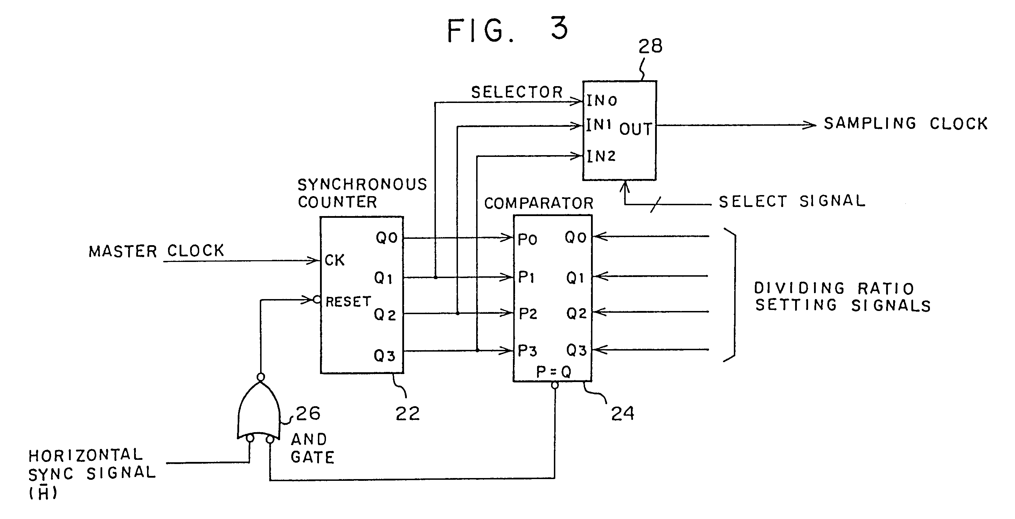

Fig. 3 is a circuit diagram showing, as an example, the arrangement of the programmable frequency divider 2. In the circuit arrangement, a synchronous counter 22 is reset by the horizontal sync signal and counts the master clock. The count value is compared with a preset frequency dividing ratio by the comparator 24, which produces a coincidence signal when the two values are equal. The preset dividing ratio is a ratio which is decided by modifying the ratio N_{S} to match this particular circuit. The coincidence signal is used to reset the counter by way of an AND gate 26.

These operations are repeated until the next horizontal sync signal is applied. Among the outputs of the counter 22, an output which matches with the dividing ratio N_{S} is selected as the sampling clock by a selector 28.

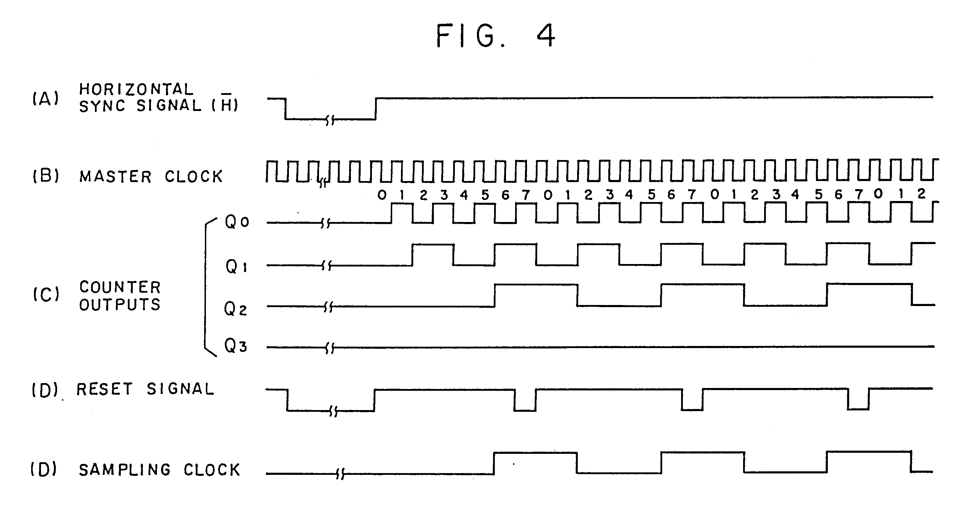

Fig. 4 is a timing chart showing the waveform of various signals of the case where the frequency dividing ratio N_{S} is 8, i.e., the preset frequency dividing ratio is 7. In this case, the selector 28 selects output Q₂ of the counter 22.

In case, for example, master clock frequency varies in the range of 100-80% of the maximum frequency, the sampling clock frequency can take the range of 25-10% of the maximum master clock frequency through the setting of frequency dividing ratios 4, 5, 6, 7 and 8 for the programmable frequency divider 2. If a frequency division circuit is added at the later stage of the programmable frequency divider 2, a sampling clock having further lower frequency can be generated.

In this way, a sampling clock is equal in phase with a horizontal sync signal within an error of one clock period of a master clock, and a sampling clock having a frequency N_{M}/N_{S} times the reference frequency can be produced.

As described above, according to the present invention, a master clock generated at a variable-frequency master clock oscillator based on the frequency synthesizer which can generate variable frequencies that are multiples of a stable reference frequency, is divided by a programmable frequency divider that is reset by the horizontal sync signal inputted from the outside, whereby a sampling clock is produced. Accordingly, the present invention has the effect that a sampling clock having a stable and various range of frequencies can be obtained irrespective of the stability of the horizontal sync signal.

## Claims

1. A sampling clock output generating circuit for generating a sampling clock output on the basis of a horizontal synchronization signal of a video signal, comprising:
a variable frequency master clock oscillator (1) working as a frequency synthesizer having a PLL loop comprising a reference oscillator (3) of a stable frequency f_{ref}, a phase comparator (4), a low-pass filter (5), a first programmable frequency divider (7) with a dividing ratio of N_{M}, N_{M} being an integer number, and a voltage controlled oscillator (6) providing a preset master clock frequency of f_{ref} · N_{M}; and
a second programmable frequency divider (2) having a counter (22) and a dividing ratio of N_{S};
characterized in that
the counter (22) has four outputs and is reset by the horizontal synchronization signal and by a coincidence signal produced by a comparator (24) when the count value of said counter (22) coincides with a preset value that corresponds to the dividing ratio of N_{S} of the counter (22) for dividing the frequency of the voltage controlled oscillator (6) so as to produce the sampling clock output synchronized with the horizontal synchronization signal and having a pulse repetition frequency of f_{ref} · N_{M}/N_{S}; and
that a selector (28) is provided for selecting one of the four outputs of the counter (22) as sampling clock output according to the dividing ratio N_{S}.

## Patentansprüche

1. Abtasttaktausgabeerzeugungsschaltung zum Erzeugen eines Abtasttaktausgangssignales auf der Basis eines Horizontal-Synchronisations-Signales eines Videosignales, mit:
einem veränderbaren Frequenzhaupttaktoszillator (1), der als ein Frequenzsynthesizer mit einer PLL-Schleife arbeitet, welche einen Referenzoszillator (3) einer stabilen Frequenz f_{ref}, einen Phasenkomparator (4), einen Tiefpassfilter (5), einen ersten programmierbaren Frequenzteiler (7) mit einem Teilerverhältnis von N_{M} aufweist, wobei N_{M} einen ganze Zahl ist, und einem spannungsgesteuerten Oszillator (6), welcher eine voreingestellte Haupttaktfrequenz von f_{ref} · N_{M} abgibt; und einem zweiten programmierbaren Frequenzteiler (2) mit einem Zähler (22) und einem Teilerverhältnis von N_{S};
dadurch gekennzeichnet,
daß der Zähler (22) vier Ausgänge aufweist und durch das Horizontal-Synchronisations-Signal und durch ein Koinzidenzsignal zurückgesetzt wird, welches durch einen Komparator (24) erzeugt wird, wenn der Zählwert des Zählers (22) mit einem vorbestimmten Wert übereinstimmt, der dem Teilerverhältnis N_{S} des Zählers (22) zum Teilen der Frequenz des spannungsgesteuerten Oszillators (6) entspricht, um das Abtasttaktausgangssignal synchronisiert mit dem Horizontal-Synchronisierungs-Signal und mit einer Impulswiederholfrequenz von f_{ref} · N_{M}/N_{S} zu erzeugen; und
daß ein Selektierer (28) zum Selektieren von einem der vier Ausgänge des Zählers (22) als Abtasttaktausgang gemäß dem Teilerverhältnis N_{S} vorgesehen ist.

## Revendications

1. Circuit générateur de sortie d'horloge d'échantillonnage pour produire une sortie d'horloge d'échantillonnage sur la base d'un signal de synchronisation de lignes d'un signal vidéo, comprenant :
un oscillateur d'horloge centrale à fréquence variable (1) fonctionnant comme un synthétiseur de fréquence ayant une boucle à phase asservie (PLL) comprenant un oscillateur de référence (3) à fréquence stable f_{ref}, un comparateur de phase (4), un filtre passe-bas (5), un premier diviseur de fréquence programmable (7) avec un rapport de division de N_{M}, N_{M} étant un nombre entier, et un oscillateur commandé en tension (6) délivrant une fréquence d'horloge centrale préréglée de f_{ref} · N_{M} ; et
un second diviseur de fréquence programmable (2) ayant un dispositif de comptage (22) et un rapport de division de N_{S} ;
caractérisé en ce que
le dispositif de comptage (22) a quatre sorties et est remis à zéro par le signal de synchronisation de lignes et par un signal de coïncidence produit par un circuit comparateur (24) lorsque la valeur de comptage dudit dispositif de comptage (22) coïncide avec une valeur préréglée correspondant au rapport de division de N_{S} du dispositif de comptage (22) pour diviser la fréquence de l'oscillateur commandé en tension (6) de manière à produire la sortie de l'horloge d'échantillonnage en synchronisation avec le signal de synchronisation de lignes et ayant une fréquence de récurrence d'impulsion de f_{ref} · N_{M}/N_{S} ; et
en ce qu'un sélecteur (28) est prévu pour sélectionner une des quatre sorties du dispositif de comptage (22) comme sortie d'horloge d'échantillonnage en fonction du rapport de division N_{S}.
